# EUROPEAN PATENT APPLICATION

(11) **EP 2 395 376 A1**
(43) Date of publication of application: **14.12.2011**
(21) Application number: 10738516.3
(22) Date of filing: 02.02.2010
(51) Int. Cl.: G02B 5/18, G02B 5/30, G02B 27/46, H01L 27/14, H04N 5/335

(54) **PHASE TYPE DIFFRACTION ELEMENT, MANUFACTURING METHOD THEREOF, AND IMAGE CAPTURE DEVICE**

(30) Priority: 03.02.2009 JP 2009022727
(71) Applicant: Toppan Printing Co., Ltd., Tokyo 110-8560 (JP)
(72) Inventor: AKAO, Sosuke, Tokyo 110-0016 (JP); ITOI, Takeshi, Tokyo 110-0016 (JP)
(74) Representative: TBK
(86) International application number: PCT/JP2010/051429
(87) International publication number: WO 2010/090184

(57) **Abstract**

A phase-type diffraction device is provided, which includes a transparent substrate (2) having a front surface and a rear surface, and a solidified liquid crystal layer (3) formed on the front surface of the transparent substrate and constituted by a continuous film comprising at least a liquid crystal compound. The solidified liquid crystal layer is constituted by first and second regions (3a, 3i) arranged periodically. The first region is optically anisotropic and the second region is optically isotropic. The first region differs in in-plane average refractive index from the second region.

## Description

### Technical Field

This invention relates to a phase-type diffraction device to be used as a low pass filter in an image pick-up device and the like wherein a large number of light-receptive pixels each formed, for example, of a charge-coupled device (CCD), a complementary metal oxide-semiconductor (CMOS) are periodically arranged, and also relates to the manufacturing method of the phase-type diffraction device. This invention also relates to an image pick-up apparatus employing the diffraction device.

### Background Art

In an image pick-up optical system employing an image pick-up device constituted by CCD, CMOS and the like, a colored light component (moire) which is different from the light originating from a subject body is caused to generate concomitant with the generation of false signals. In order to suppress the generation of moiré, an optical low pass filter which restricts a high spatial frequency of the light of the subject body is generally employed.

With respect to the optical low pass filter, a birefringence type filter which utilizes the separation of ordinary ray and extraordinary ray in a birefringent substance is conventionally widely used. The materials constituting the birefringence type optical low pass filter which have been most widely employed are formed of inorganic crystals such as quartz, lithium niobate, etc. The birefringence type optical low pass filter made from an inorganic crystal is formed into a platelike body through processes wherein a single crystal is synthesized at first and then subjected to post workings such as cutting, polishing, etc. Because of these processes, the conventional optical low pass filter is accompanied with the drawbacks that considerable time and labor are required for the manufacture thereof.

With a view to overcome these problems, there has been proposed the employment of a photo-reactive liquid crystal composition as a material for the birefringence type optical low pass filter. For example, Jpn. Pat. No. 3592383 describes a method wherein a thin film of a photo-reactive liquid crystal composition is formed at first and then polymerized in such a manner that the mesogens of liquid crystal is obliquely inclined from the normal direction of the thin film, thereby making it possible to obtain desired optical properties. Alternatively, JP-A 2007-93918 describes a method wherein a thin film of a photo-reactive liquid crystal composition is polymerized in such a manner that the inclined angle of the mesogens from the normal direction is continuously changed in the thickness direction of the thin film, thereby obtaining desired optical properties.

However, it is difficult to uniformly orientate the mesogens in an inclined angle from the normal direction, especially at an angle of 20 to 70 degrees. When it is tried to create a construction wherein the inclined angle of the mesogens from the normal direction is continuously changed in the thickness direction of the thin film, since the separating width of the beam becomes smaller relative to the thickness of film, the thickness of the thin film is required to be increased.

Meanwhile, with respect to the optical low pass filter, a diffraction grating type device which utilizes the separation of light by diffraction is also widely employed other than the system which separates the beam of light by birefringence. With respect to the diffraction grating type low pass filter, one which is most commonly employed is a phase-type diffraction device. As described in JP-A 4-9803 for example, this phase-type diffraction device is constructed such that it comprises a plate having a periodical recessed/projected pattern on its surface created by a transparent material such as a transparent resin, thereby making it possible to create a phase difference of light between the recessed portions and the projected portions.

The phase-type diffraction grating utilizing the recessed/projected pattern is accompanied with a problem that a shadow of the grating is more likely to be generated due to the non-flatness of the surface of the device. Further, this phase-type diffraction grating is accompanied with a problem that it is difficult to enhance the diffraction efficiency, so that this phase-type diffraction grating is not suited for use in an image pick-up apparatus which is intended to obtain images of high-quality.

### Disclosure of Invention

Objects of the present invention are to overcome the aforementioned problems and to provide a phase-type diffraction device of high quality and to provide a method of easily and stably manufacturing such a phase-type diffraction device. A further object of the present invention is to provide an image pick-up apparatus wherein the aforementioned diffraction device is employed as a low pass filter.

According to a first aspect of the present invention, there is provided a phase-type diffraction device characterized by comprising a transparent substrate having a front surface and a rear surface; and a solidified liquid crystal layer formed on the front surface of the transparent substrate and constituted by a continuous film comprising at least a liquid crystal compound; wherein the solidified liquid crystal layer is constituted by first and second regions arranged periodically; the first region is optically anisotropic and the second region is optically isotropic; and the first region differs in in-plane average refractive index from the second region.

According to a second aspect of the present invention, there is provided an image pick-up apparatus comprising an image pick-up device provided with a large number of light-receptive pixels which are periodically arranged and with a phase-type diffraction device described above as a low pass filter.

According to a third aspect of the present invention, there is provided a method of manufacturing a phase-type diffraction device, characterized by comprising forming a solidified liquid crystal layer, directly or through another layer, on a front surface of a transparent substrate, the formation of the solidified liquid crystal layer comprising a film-forming step of forming, on the front surface of the transparent substrate, a liquid crystal material layer comprising a photo-polymerizable or photo-crosslinkable thermotropic liquid crystal compound, mesogens of the thermotropic liquid crystal compound configuring a prescribed oriented structure; an exposure step of exposing partial regions of the liquid crystal material layer to light, thereby forming, in the liquid crystal material layer, a first region comprising a reaction product formed of the polymerized or crosslinked thermotropic liquid crystal compound and a second region which is free from the reaction product and comprises unreacted thermotropic liquid crystal compound; thereafter, a developing step of heating the liquid crystal material layer to a temperature equal to or higher than a phase transition temperature at which the thermotropic liquid crystal compound changes from a liquid crystal phase to an isotropic phase, thereby disturbing the orientation of the mesogens of the unreacted thermotropic liquid crystal compound in the second region to turn the second region into the isotropic phase; and a fixing step of polymerizing and/or crosslinking the unreacted compound while maintaining a state of the isotropic phase of the second region.

According to the present invention, it is possible to provide a phase-type diffraction device of high quality, which can be easily and stably manufactured. Further, according to the present invention, it is possible to realize an image pick-up apparatus wherein the aforementioned phase-type diffraction device is employed as a low pass filter.

### Brief Description of Drawings

FIG. 1 is a diagram schematically illustrating the optical system of an image pick-up apparatus according to one aspect of the present invention;
FIG. 2 is a perspective view schematically showing a portion of a diffraction device according to one aspect of the present invention;
FIG. 3 is a cross-sectional view taken along the line I-I of one example of the diffraction device shown in FIG. 2;
FIG. 4 is a cross-sectional view taken along the line I-I of another example of the diffraction device shown in FIG. 2;
FIG. 5 is a cross-sectional view taken along the line I-I of a further example of the diffraction device shown in FIG. 2;
FIG. 6 is a perspective view schematically showing a portion of a diffraction device according to another aspect of the present invention;
FIG. 7 is a cross-sectional view illustrating the state of separation of incident light; and
FIG. 8 is a diagram illustrating the state of separation of incident light.

### Best Mode for Carrying Out the Invention

Next, various aspects of the present invention will be explained in detail with reference to the drawings. Incidentally, constituent components exhibiting the same or a similar function are identified by the same reference number throughout all of the drawings, thereby omitting a duplicated explanation thereof.

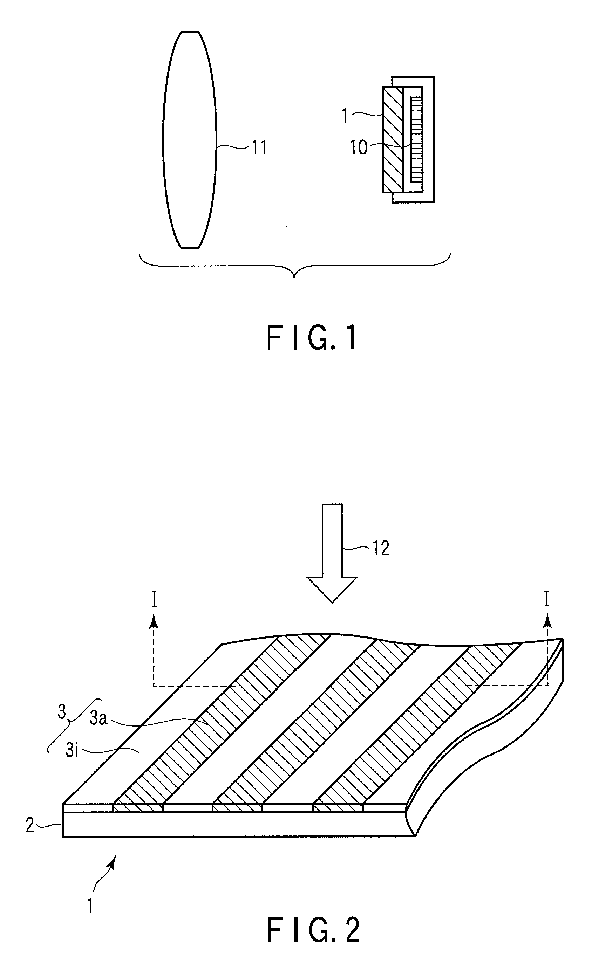

FIG. 1 is a diagram schematically illustrating the optical system of an image pick-up apparatus according to one aspect of the present invention. This optical system is constructed such that a diffraction device 1 is interposed between the image pick-up device 10 having a large number of light-receptive pixels arranged periodically thereon and an image pick-up lens 11. This diffraction device 1 is constituted at least by a solidified liquid crystal layer acting as a diffraction grating, and a transparent substrate supporting this solidified liquid crystal layer. As long as it is possible to enable this diffraction device 1 to exhibit desired properties as a low pass filter, it can be disposed at any desired place. However, it is preferable to dispose this diffraction device 1 in the vicinity of the image pick-up device in such a manner that the solidified liquid crystal layer thereof is directed to face the image pick-up device. The reason for disposing the diffraction device 1 in this manner is that the interval between the solidified liquid crystal layer acting as a diffraction grating and the image pick-up device can be easily adjusted to a prescribed value, thereby making it possible to easily utilize the transparent substrate as a protecting layer.

FIG. 2 is a perspective view schematically showing a portion of a diffraction device according to one aspect of the present invention. The diffraction device 1 shown herein comprises a transparent substrate 2, and a solidified liquid crystal layer 3 formed on the surface of the transparent substrate 2.

The transparent substrate 2 is typically formed of a light-transmitting substrate made of a glass plate or a resin plate. Examples of the glass plate include, for example, soda-lime glass, low-alkali boro-silicate glass and non-alkali amino boro-silicate glass. Examples of the resin plate include, for example, polycarbonate, poly methyl methacrylate and polyethylene terephthalate.

The transparent substrate 2 need not necessarily be formed of a hard material. For example, it is possible to employ a light-transmitting film such as a plastic film or a light-transmitting sheet such as a plastic sheet.

The solidified liquid crystal layer 3 is a continuous film which is formed using a material containing at least a liquid crystal compound and comprises a first region 3a and a second region 3i which are arranged periodically. In the structure shown in FIG. 2, although the first region 3a and second region 3i are arranged in a pattern of stripes, the pattern thereof is not limited to this one. As described hereinafter, the first region 3a and second region 3i may be arranged so as to constitute a pattern of a checkers board.

Irrespective of the arrangements thereof, the first region 3a is optically anisotropic and the second region 3i is optically isotropic. The anisotropic region (the first region) 3a and the isotropic region (the second region) 3i are different from each other in apparent refractive index with respect to the light 12 to be entered into each of film surfaces from the normal direction (i.e. in in-plane average refractive index). On the other hand, irrespective of the kind of polarized light component of the light 12 or irrespective of the polarized state of the light 12, it is preferable that the apparent refractive index is the same at the same region of the film surface. Not only the first region 3a but also the second region 3i, i.e. any region of the entire solidified liquid crystal layer 3 is preferably constructed not to substantially exhibit isotropy in in-plane directions, in other words, not to substantially exhibit an in-plane birefrigence. Incidentally, by the expression of "not to substantially exhibit", it is intended to indicate a state wherein the in-plane phase difference And to be determined by the product of the film thickness "d" of the solidified liquid crystal layer 3 and the in-plane phase difference Δn is confined to less than 10 nm.

Namely, it can be said that, throughout the solidified liquid crystal layer 3, although it exhibits anisotropy in the thickness direction thereof, it exhibits isotropy in the in-plane direction thereof. In other words, irrespective of the polarized state of the light, the apparent refractive index is the same as long as the region of the film surface is the same.

As described above, the region 3i which is optically isotropic and the region 3a which is optically anisotropic are different from each other in in-plane average refractive index. Due to this difference in in-plane average refractive index, a phase difference is generated between these regions as the incident light 12 is applied to the solidified liquid crystal layer 3. Since these two regions are periodically arranged, the solidified liquid crystal layer 3 acts as a phase-type diffraction grating.

Meanwhile, since the in-plane birefringence of the entire solidified liquid crystal layer 3 is substantially zero, the solidified liquid crystal layer 3 has equivalent optical properties to any of polarized light components of the incident light 12. With respect to the phase difference to be provided by both of these regions against the incident light 12, when it is approximately 1/2 of the wavelength of the light beam, the diffraction device according to this embodiment is enabled to obtain most excellent properties. Because of this, it is desirable to set the thickness of the solidified liquid crystal layer 3 in such a manner that it provides a phase difference corresponding to 1/2 of the wavelength of the incident light. Generally, the thickness of the solidified liquid crystal layer 3 may be set to 1∼30 µm or so.

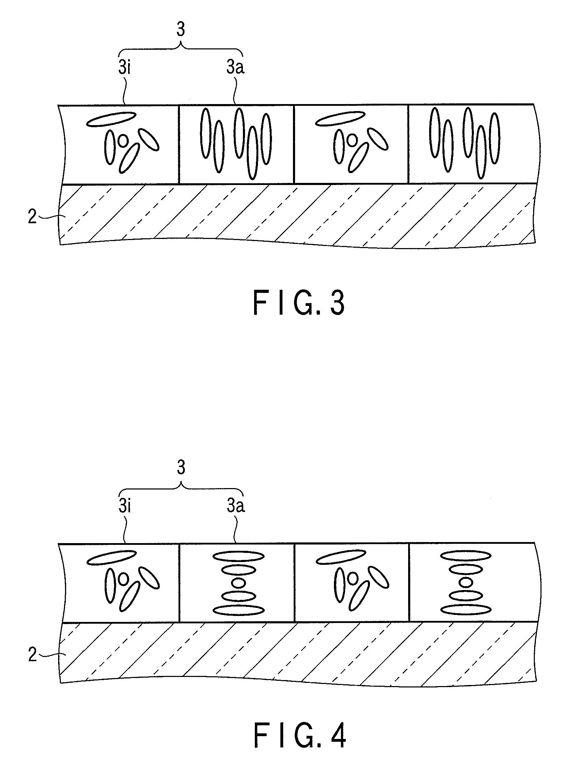

With respect to the structure of the region 3a of the solidified liquid crystal layer 3 which is optically anisotropic, it may be optionally selected as long as the in-plane average refractive index thereof differs from that of the optically isotropic region 3i. FIGS. 3∼5 show schematically various examples of such a structure. Namely, FIGS. 3∼5 show respectively a cross-sectional view taken along the line I-I of the diffraction device shown in FIG. 2.

In FIGS. 3 and 4, the liquid crystal compound contained in the solidified liquid crystal layer 3 is formed of rod-like liquid crystals. In FIG. 3, mesogens in the optically anisotropic region 3a are immobilized in a homeotropic orientation (case 1). In FIG. 4, mesogens in the optically anisotropic region 3a are immobilized in a cholesteric orientation (case 2).

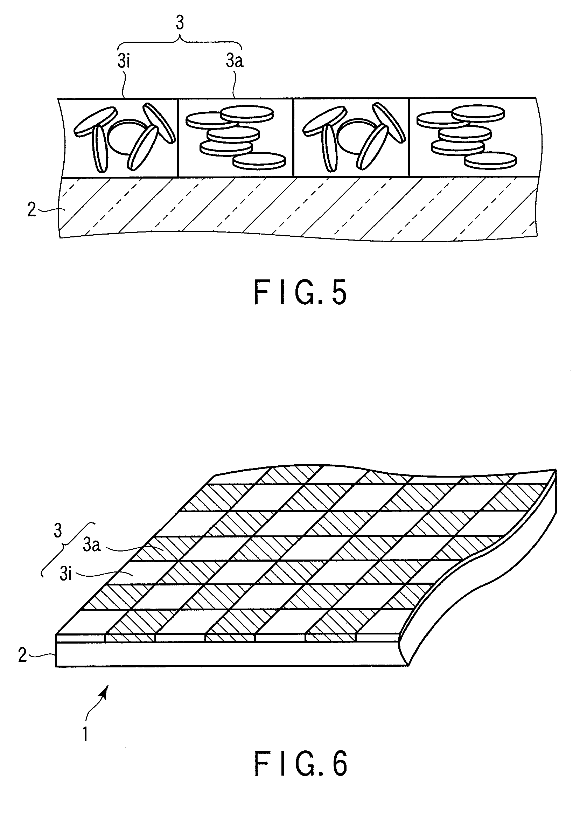

In FIG. 5, the liquid crystal compound contained in the solidified liquid crystal layer 3 is formed of disc-like liquid crystals and mesogens in the optically anisotropic region 3a are immobilized in a homeotropic orientation (case 3).

In the case of the structure of case 1, the optically anisotropic region 3a becomes smaller in in-plane average refractive index as compared with the optically isotropic region 3i. Because of this, the optically anisotropic region 3a acts to advance the phase of the incident light 12. On the other hand, in the cases of the structures of case 2 and case 3, the optically anisotropic region 3a becomes larger in in-plane average refractive index as compared with the optically isotropic region 3i, so that the optically anisotropic region 3a acts to retard the phase of the incident light 12.

In the diffraction device of this embodiment, the periodically structure created in the solidified liquid crystal layer is not necessarily a one-dimensional configuration. Rather, it is preferable to arrange the optically anisotropic region 3a and the optically isotropic region 3i in a two-dimensional configuration such as a checkerboard pattern. The reason for this is that when these regions are formed in a two-dimensional configuration, it is possible, in this case, to enable these regions to agree with the construction of the image pick-up device where light-receptive pixels are generally arranged as a two-dimensional pattern. In order to separate the incident light 12 in conformity with the arrangement of the light-receptive pixels of an image pick-up device that is arranged up and down as well as right and left, the grating constituted by the optically isotropic region 3i and the optically anisotropic region 3a is preferably obliquely arranged at an angle of approximately 45° rather than being arranged up and down as well as right and left on the substrate of the diffraction device. FIG. 6 illustrates, as one embodiment, a portion of the diffraction device having the solidified liquid crystal layer 3 having such an arrangement.

If the diffraction device of this embodiment is to be employed as a low pass filter suitable for use in an image pick-up device having a large number of light-receptive pixels arranged periodically, the period defined by the optically isotropic region 3i and the optically anisotropic region 3a is preferably 20 µm or more. Incidentally, by the term "period", it is intended to indicate a length of one group consisting of the region 3i and the region 3a in the direction in which the region 3a and the region 3i are repeatedly arranged. Namely, when these two regions are arranged forming a pattern of stripes as shown in FIG. 2, the term "period" indicates a total of the width of the region 3a and the width of the region 3i. When these two regions are arranged forming a checkerboard pattern as shown in FIG. 6, the term "period" indicates a total of the length of one side of the region 3a and the length of one side of the region 3i.

The pitch of light-receptive pixels in the image pick-up device is usually constituted by a period of 10 µm or less. When the period of these regions formed in the diffraction device is less than 20 µm, the width of the separation of light becomes too large relative to the pitch of the light-receptive pixels of the image pick-up device. In addition to this problem, it would become difficult to reliably create the optically isotropic region 3i and the optically anisotropic region 3a of the solidified liquid crystal layer 3 using a material containing a liquid crystal compound.

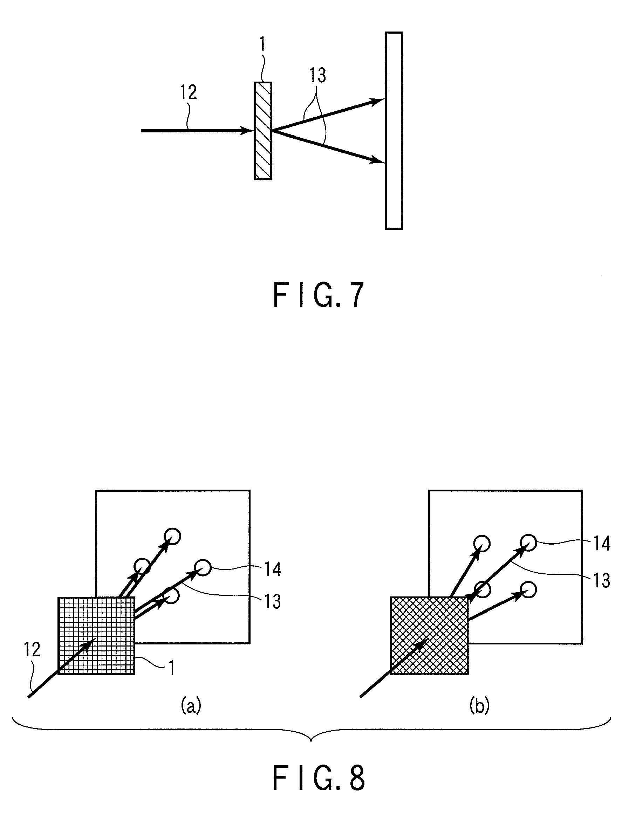

FIG. 7 is a cross-sectional view illustrating the state of separation of incident light 12. As shown in FIG. 7, separated diffraction beams 13 are caused to generate as the incident light 12 passes through the diffraction device 1. FIG. 8 is a diagram illustrating the state of separation of incident light. When the incident light 12 is separated by the diffraction device 1, separated light spots 14 are caused to generate. FIG. 8(a) shows one embodiment wherein the grating consisting of the optically isotropic region 3i and the optically anisotropic region 3a is arranged up and down as well as right and left. FIG. 8(b) shows another embodiment wherein these two regions are obliquely arranged at an angle of approximately 45°.

The diffraction device according to one aspect of the present invention is designed to provide a difference of in-plane average refractive index between the optically isotropic region 3i and the optically anisotropic region 3a of the solidified liquid crystal layer 3, thereby creating a phase difference in the incident light 12 between these two regions. It is not required to create a difference of film thickness between the optically isotropic region 3i and the optically anisotropic region 3a. Namely, the entire solidified liquid crystal layer 3 may be uniform in film thickness. Of cause, it is possible to create a difference of film thickness between the optically isotropic region 3i and the optically anisotropic region 3a. However, in viewpoint of preventing the shadow of the grating from falling on the image pick-up device, the difference in film thickness of these regions is as small as possible. More preferably, the difference in film thickness of these regions is reduced to zero.

Incidentally, in the case of the diffraction device according to this embodiment, an antireflection film may be attached to the surface (rear face) where the solidified liquid crystal layer 3 of transparent substrate 2 is not formed. Due to this antireflection film, it is possible to minimize any redundant light reflection on the surface of the substrate, thereby making it possible to suppress the deterioration of quality of the picture image to be displayed on the image pick-up apparatus that may be brought about by the irregular reflection of the light reflection in the interior of the image pick-up apparatus when building the diffraction device of this embodiment into the image pick-up apparatus.

Further, an antistatic film may be attached to a surface opposite to the surface where the transparent substrate 2 of the solidified liquid crystal layer 3 is disposed. Due to this antistatic film, it is possible to prevent the solidified liquid crystal layer 3 from being electrified and hence to suppress the adhesion of undesirable foreign matter. This antistatic film can be formed by forming an electrically conductive thin film such as an indium tin oxide film on the solidified liquid crystal layer 3.

Next, a method of forming the solidified liquid crystal layer 3 will be explained as follows.

The solidified liquid crystal layer 3 can be obtained, for example, through a method wherein a liquid crystal material layer containing a photo-polymerizable or a photo-crosslinkable thermotropic liquid crystal material is formed on the transparent substrate 2 and then the resultant liquid crystal material layer is subjected to patterning exposure and to heat treatment.

The liquid crystal material layer can be obtained, for example, through a method wherein a solution of liquid crystal containing a thermotropic liquid crystal compound and a solvent is coated on the transparent substrate 2 and then the resultant coated layer is subjected, if required, to drying. In this liquid crystal material layer, the mesogens of the thermotropic liquid crystal compound are orientated in a subscribed manner.

Examples of the thermotropic liquid crystal compound include, for example, alkyl cyanobiphenyl, alkoxy biphenyl, alkyl terphenyl, phenyl cyclohexanone, biphenyl cyclohexane, phenyl bicyclohexane, pyrimidine, cyclohexane carbonate, halogenated cyanophenol ester, alkyl benzoate, alkyl cyanotolane, dialkoxytolane, alkyl alkoxytolane, alkyl cyclohexyltolane, alkyl bicyclohexane, cyclohexyl phenylethylene, alkylcyclohexyl cyclohexene, alkyl benzaldehyde azine, alkenyl benzaldehyde azine, phenyl naphthalene, phenyl tetrahydronaphthalene, phenyl decahydronaphthalene, triphenylene, pentaethynyl benzene, hydroxypropyl cellulose, acenaphthoquinoxaline, indanthrone, cyanine indanthrone, perylene dibenzoimidazole tetracarbonate, naphthoylene benzoimidazole, chromoglic acid, methylphenyl diazenyl naphthalene sulfonic acid, derivatives of these compounds and acrylates of these compounds. These liquid crystal compounds may be employed singly or in combination thereof.

Examples of the solvent include, for example, cyclohexanone, ethyl Cellosolve acetate, butyl Cellosolve acetate, 1-methoxy-2-propyl acetate, diethyleneglycol dimethyl ether, ethyl benzene, ethyleneglycol diethyl ether, xylene, ethyl Cellosolve, methyl-n-amyl ketone, propyleneglycol monomethyl ether, toluene, methylethyl ketone, ethyl acetate, methanol, ethanol, isopropyl alcohol, butanol, isobutyl ketone, petroleum solvent, etc. These solvents may be employed singly or in combination thereof.

In addition to the above-mentioned components, the solution of liquid crystal may further contain, for example, a chiral agent, a resin, a polyfunctional monomer and/or oligomer, a photopolymerization initiator, a sensitizer, a thermopolymerization initiator, a chain-transfer agent, a surfactant, a polymerization inhibitor, a storage stabilizer, an adherence improver, etc. to such an extent that would not cause the composition containing any of these liquid crystal compounds to vanish the liquid crystallinity of the composition.

The chiral agent is a low molecular weight compound having an optically active moiety, main examples of the low molecular weight compound being those having a molecular weight of 1500 or less. The chiral agent is employed for the purpose of inducing a helical structure to the positive uniaxial nematic regularity to be developed by a polymerizable liquid crystal material exhibiting nematic regularity. As long as this purpose can be attained, there is no limitation as to the kind of chiral agent to be employed. The compound that can be used as a chiral agent may be selected from any kind of compound as long as it is capable of being made compatible with a polymerizable liquid crystal compound exhibiting nematic regularity in a dissolved state or in a fused state and also capable of inducing a desired helical structure to the liquid crystal compound without damaging the liquid crystallinity of the polymerizable liquid crystal compound.

Since the chiral agent is used for inducing a helical structure to the liquid crystal compound, the chiral agent is required to contain at least any sort of chirality in its molecule. Therefore, the chiral agent to be employed herein is preferably selected from the group consisting of a compound having at least one asymmetric carbon atom, a compound having an asymmetric point on a heteroatom such as chiral amine or chiral sulfoxide, and a compound having an axial asymmetry and an optically active moiety such as cumulene and binaphthol. More specifically, it is possible to employ a chiral nematic liquid crystal (for example, Paliocolor LC756 available from BASF Co.) or chiral dopant liquid crystal "S-811" (available from Merck Co.).

Although it depends on the power of inducing the helical structure, the effects of the chiral agent can be attained as long as the chiral agent is contained in a thermotropic liquid crystal compound at a ratio of 2 to 30 parts by weight or so based on 100 parts by weight of a thermotropic liquid crystal compound.

With respect to the resin, it may be a thermoplastic resin or thermosetting resin. Examples of the thermoplastic resin include, for example, butyral resin, styrene-maleic acid copolymer, chlorinated polyethylene, chlorinated polypropylene, polyvinyl chloride, vinyl chloride-vinyl acetate copolymer, polyvinyl acetate, polyurethane resin, polyester resin, acrylic resin, alkyd resin, polystyrene, polyamide resin, rubber type resin, cyclized rubber-based resin, celluloses, polybutadien, polyethylene, polypropylene, polyimide, etc. Examples of the thermosetting resin include, for example, epoxy resin, benzoguanamine resin, rosin-modified maleic resin, rosin-modified fumaric acid resin, melamine resin, urea resin, phenol resin, etc.

Further, it is also possible to employ a photosensitive resin. As for the photosensitive resin, it is possible to employ resins having a linear macromolecule into which a photo-curable group such as a acryloyl group, (metha)acryloyl group, styryl group, etc. has been introduced through a reaction between a linear macromolecule having a reactive substituent group such as a hydroxyl group, carboxyl group, amino group, etc. and an acrylic compound or (metha)acrylic compound having a reactive substituent group such as an isocyanate group, aldehyde group, epoxy group, etc. or cinnamic acid. It is also possible to employ a resin wherein a linear macromolecule containing an acid anhydride such as a styrene-maleic anhydride copolymer or α-olefin-maleic anhydride copolymer is half-esterified with an acrylic compound or (metha)acrylic compound having a hydroxyl group such as hydroxyalkyl acrylate or hydroxyalkyl (metha)acrylate.

As the monomers and oligomers which are the precursors of the resin, they include, for example, various kinds of acrylic esters and methacrylic esters such as 2-hydroxyethyl acrylate, 2-hydroxyethyl(metha)acrylate, 2-hydroxypropyl acrylate, 2-hydroxypropyl(metha)acrylate, cyclohexyl acrylate, cyclohexyl(metha)acrylate, polyethyleneglycol diacrylate, polyethyleneglycol di(metha)acrylate, pentaerythritol triacrylate, pentaerythritol tri(metha)acrylate, trimethylolpropane triacrylate, trimethylolpropane tri(metha)acrylate, dipentaerythritol hexaacrylate, dipentaerythritol hexa(metha)acrylate, tricyclodecanyl acrylate, tricyclodecanyl (metha)acrylate, melamine acrylate, melamine (metha)acrylate, epoxy acrylate, epoxy(metha)acrylate, etc.; acrylic acid; (metha)acrylic acid; styrene; vinyl acetate; acryl amide; (metha)acryl amide; N-hydroxymethyl acryl amide; N-hydroxymethyl (metha)acryl amide; acrylonitrile; etc. These compounds can be employed either singly or as a mixture of two or more kinds thereof.

When the liquid crystal layer is cured through the irradiation of light such as ultraviolet rays, a photo-polymerization initiator, for example, can be incorporated in a liquid crystal solution.

Examples of the photo-polymerization initiator include an acetophenone-based photo-polymerization initiator such as 4-phenoxy dichloroacetophenone, 4-t-butyl-dichloroacetophenone, diethoxyacetophenone, 1-(4-isopropylphenyl)-2-hydroxy-2-methylpropan-1-one, 1-hydroxycyclohexylphenyl ketone, 2-methyl-1[4-(methylthio)phenyl]-2-morpholinopropane-1-one, 2-benzyl-2-dimethylamino-1-(4-morpholinophenyl)-butan-1-one; a benzoin-based photo-polymerization initiator such as benzoin, benzoin methyl ether, benzoin ethyl ether, benzoin isopropyl ether, benzyldimethyl ketal, etc.; a benzophenone-based photo-polymerization initiator such as benzophenone, benzoylbenzoic acid, benzoylmethyl benzoate, 4-phenyl benzophenone, hydroxybenzophenone, acrylated benzophenone, 4-benzoyl-4'-methyldiphenyl sulfide, etc.; a thioxanthone-based photo-polymerization initiator such as thioxanthone, 2-chlorothioxanthone, 2-methylthioxanthone, isopropylthioxanthone, 2,4-diisopropylthioxanthone, etc.; a triazine-based photo-polymerization initiator such as 2,4,6-trichloros-triazine, 2-phenyl-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-piperonyl-4,6-bis(trichloromethyl)-s-triazine, 2,4-bis(trichloromethyl)-6-styryl-s-triazine, 2-(naphtho-1-yl)-4,6-bis(trichloromethyl)-s-triazine, 2-(4-methoxynaphtho-1-yl)-4,6-bis(trichloromethyl)-s-triazine, 2,4-trichloromethyl-(piperonyl)-6-triazine, 2,4-trichloromethyl(4'-methoxystyryl)-6-triazine, etc.; a borate-based photo-polymerization initiator; a carbazol-based photo-polymerization initiator; an imidazole-based photo-polymerization initiator, etc.

These photo-polymerization initiators can be employed singly or in combination of two or more kinds thereof. The content of the photo-polymerization initiator is preferably be confined to 0.1∼30 parts by weight, more preferably 0.3∼10 parts by weight, based on 100 parts by weight of the liquid crystalline compound in a liquid crystal solution.

These photo-polymerization initiators can be employed in combination with a sensitizer. Examples of which include α-acyloxy ester, acylphosphine oxide, methylphenyl glyoxylate, benzyl, 9,10-phenanthrene quinone, camphor quinine, ethylanthraquinone, 4,4'-diethyl isophthalophenone, 3,3',4,4'-tetra(t-butyl peroxycarbonyl)benzophenone, 4,4'-diethylaminobenzophenone, etc.

These sensitizers can be employed at an amount ranging from 0.1 to 60 parts by weight based on 100 parts by weight of the photo-polymerization initiator.

Examples of the thermopolymerization initiator include, for example, peroxide initiators such as benzoyl peroxide (BPO), t-butylperoxy-2-ethylhexanate (PBO), di-t-butylperoxide (PBD), t-butylperoxyisopropyl carbonate (PBI), n-butyl-4,4-bis(t-butylperoxy) paralate (PIIV), etc.; and azo-based initiators such as 2,2'-azobisisobutyronitrile, 2,2'-azobis(2-methylbutyronitrile), 1,1'-azobis(cyclohexane-1-carbonitrile), 2,2'-azobis(2-methylpropane), 2,2'-azobis(2-methylbutane), 2,2'-azobis(2-methylpentane), 2,2'-azobis(2,3-dimethylbutane), 2,2'-azobis(2-methylhexane), 2,2'-azobis(2,4-dimethylpentane), 2,2'-azobis(2,3,3-trimethylbutane), 2,2'-azobis(2,4,4-trimethylpentane), 3,3'-azobis(3-methylpentane), 3,3'-azobis(3-methylhexane), 3,3'-azobis(3,4-dimethylpentane), 3,3'-azobis(3-ethylpentane), dimethyl-2,2'-azobis(2-methylpropionate), diethyl-2,2'-azobis(2-methylpropionate), di-tert-dimethyl-2,2'-azobis(2-methylpropionate), etc.

These thermopolymerization initiators can be employed singly or in combination of two or more kinds thereof. The content thereof may be 0.01 to 5 parts by weight based on 100 parts by weight of the liquid crystalline compound in a liquid crystal solution.

The liquid crystalline solution may further comprise a chain-transfer agent such as a polyfunctional thiol.

Polyfunctional thiol is a compound which has two or more thiol group. Examples of this polyfunctional thiol include, for example, hexane dithiol, decane dithiol, 1,4-butanediol bisthiopropionate, 1,4-butanediol bisthioglycolate, ethyleneglycol bisthioglycolate, ethyleneglycol bisthiopropionate, trimethylolpropane tristhioglycolate, trimethylolpropane tristhiopropionate, trimethylolpropane tris(3-mercaptobutylate), pentaerythritol tetrakisthioglycolate, pentaerythritol tetrakisthiopropionate, trimercaptopropionate tris(2-hydroxyethyl)isocyanulate, 1,4-dimethylmercaptobenzene, 2,4,6-trimercapto-s-triazine, 2-(N,N-dibutylamino)-4,6-dimercapto-s-triazine, etc. These polyfunctional thiols can be employed singly or in combination of two or more kinds.

The content of these polyfunctional thiols is preferably be confined within the range of 0.2 to 30 parts by weight, more preferably 0.5 to 15 parts by weight based on 100 parts by weight of the liquid crystalline compound in a liquid crystal solution.

Examples of the surfactant include, for example, an anionic surfactant such as polyoxyethylene alkylether sulfate, dodecylbenzene sodium sulfonate, alkali salts of styrene-acrylic acid copolymer, alkylnaphthaline sodium sulfonate, alkyldiphenyl ether sodium disulfonate, monoethanol amine lauryl sulfate, triethanol amine lauryl sulfate, ammonium lauryl sulfate, monoethanol amine stearate, sodium stearate, sodium lauryl sulfate, monoethanol amine of styrene-acrylic acid copolymer, polyoxyethylene alkylether phosphate, etc.; a nonionic surfactant such as polyoxyethylene oleyl ether, polyoxyethylene lauryl ether, polyoxyethylene nonylphenyl ether, polyoxyethylene alkylether phosphate, polyoxyethylene sorbitan monostearate, polyethyleneglycol monolaurate, etc.; cationic surfactant such as alkyl quaternary ammonium salt and an ethylene oxide adduct thereof, etc.; and an amphoteric surfactant such as alkyl betaine such as betaine alkyldimethyl aminoacetate, alkylimidazoline, etc. These surfactants can be employed singly or in combination of two or more kinds.

Examples of the polymerization inhibitor include, for example, phenol-based inhibitors such as 2,6-di-t-butyl-p-cresol, 3-t-butyl-4-hydroxyanisole, 2-t-butyl-4-hydroxyanisole, 2,2'-methylene bis(4-methyl-6-t-butylphenol), 2,2'-methylene bis(4-ethyl-6-t-butylphenol), 4,4'-butylidene bis(3-methyl-6-t-butylphenol), 4,4'-thiobis(3-methyl-6-t-butylphenol), styrenated phenol, styrenated p-cresol, 1,1,3-tris(2-methyl-4-hydroxy-5-t-butylphenyl) butane, tetrakis[methylene-3-(3',5'-di-1-butyl-4'-hydroxyphenyl) propionate] methane, octadecyl-3-(3,5-di-t-butyl-4-hydroxyphenyl propionate), 1,3,5-trimethyl-2,4,6-tris(3,5-di-t-butyl-4-hydroxybenzyl) benzene, 2,2'-dihydroxy-3,3'-di(α-methylcyclohexyl)-5,5'-dimethyldiphenyl methane, 4,4'-methylene bis(2,6-di-t-butylphenol), tris(3,5-di-t-butyl-4-hydroxyphenyl) isocyanurate, 1,3,5- tris(3',5'-di-t-butyl-4-hydroxybenzoyl) isocyanurate, bis[2-methyl-4-(3-n-alkylthiopropionyloxy)-5-t-butylphenyl] sulfide, 1-oxy-3-methyl-isopropyl benzene, 2,5-di-t-butylhydroquinone, 2,2'-methylene bis(4-methyl-6-nonylphenol), alkylated bisphenol, 2,5-di-t-amylhydroquinone, polybutylated bisphenol A, bisphenol A, 2,6-di-t-butyl-p-ethylphenol, 2,6-bis(2'-hydroxy-3-t-butyl-5'-methyl-benzyl)-4-methylphenol, 1,3,5-tris(4-t-butyl-3-hydroxy-2,6-dimethylbenzyl) isocyanurate, terephthaloyldi(2,6-dimethyl-4-t-butyl-3-hydroxybenzyl sulfide), 2,6-di-t-butylphenol, 2,6-di-t-butyl-α-dimethylamino-p-cresol, 2,2'-methylene-bis(4-methyl-6-cyclohexylphenol), triethyleneglycol-bis[3-(3-t-butyl-5-methyl-4-hydroxyphenyl) propionate], hexamethylene glycol-(3,5-di-t-butyl-4-hydroxyphenyl) propionate, 3,5-di-t-butyl-4-hydroxytoluene, 6-(4-hydroxy-3,5-di-t-butylaniline)-2,4-bis(octylthio)-1,3,5-triazine, N,N'-hexamethylene bis(3,5-di-t-butyl-4-hydroxy-hydrocynamide), 3,5-di-t-butyl-4-hydroxybenzyl-diethyl phosphate, 2,4-dimethyl-6-t-butylphenol, 4,4'-methylene bis(2,6-di-t-butylphenol), 4,4'-thio bis(2-methyl-6-t-butylphenol), tris[β-(3,5-di-t-butyl-4-hydroxyphenyl)propionyl-oxyethyl] isocyanulate, 2,4,6-tributylphenol, bis[3,3-bis(4'-hydroxy-3'-t-butylphenyl)-butylic acid] glycol ester, 4-hydroxymethyl-2,6-di-t-butylphenol, bis(3-methyl-4-hydroxy-5-t-butylbenzene) sulfide, etc. Further, it is also possible to employ amine-based inhibitors such as N-phenyl-N'-isopropyl-p-phenylene diamine, N-phenyl-N'-(1,3-dimethylbutyl)-p-phenylene diamine, N,N'-diphenyl-p-phenylene diamine, 2,2,4-trimethyl-1,2-dihydroquinoline polymer, diaryl-p-phenylene diamine, etc.; sulfur-based inhibitors such as dilauryl·thiodipropionate, distearyl·thiodipropionate, 2-mercaptobenz imidazole, etc.; and phosphor-based inhibitors such as distearyl pentaerythritol diphosphite, etc.

The liquid crystal solution may further contain a storage stabilizing agent for enhancing the stability of the time viscosity of the solution. Examples of the storage stabilizing agent include, for example, benzyltrimethyl chloride, quaternary ammonium chlorides such as diethylhydroxy amine, etc.; organic acids such as lactic acid, oxalic acid, etc. and methyl ethers thereof; t-butyl pyrocatechol; organic phosphine such as triethyl phosphine, triphenyl phosphine, etc.; phosphite; and a mixture containing two or more kinds of these compounds.

Further, the liquid crystal solution may contain an adherence improver such as a silane coupling agent for the purpose of enhancing the adhesion thereof to a substrate.

Examples of the silane coupling agent include vinyl silanes such as vinyl tris(β-methoxyethoxy) silane, vinylethoxy silane, vinyltrimethoxy silane, etc.; acrylsilanes or (metha)acrylsilanes such as γ-methacryloxypropyl trimethoxy silane, etc.; epoxy silanes such as β-(3,4-epoxycyclohexyl) ethyltrimethoxy silane, β-(3,4-epoxycyclohexyl) methyltrimethoxy silane, β-(3,4-epoxycyclohexyl) ethyltriethoxy silane, β-(3,4-epoxycyclohexyl) methyltriethoxy silane, γ-glycidoxypropyl trimethoxy silane, γ-glycidoxypropyl triethoxy silane, etc.; amino silanes such as N-β(aminoethyl) γ-aminopropyl trimethoxy silane, N-β(aminoethyl) γ-aminopropyl triethoxy silane, N-β(aminoethyl) γ-aminopropyl methyldiethoxy silane, γ-aminopropyl triethoxy silane, γ-aminopropyl trimethoxy silane, N-phenyl-γ-aminopropyl trimethoxy silane, N-phenyl-γ-aminopropyl triethoxy silane, etc.; and thiosilanes such as γ-mercaptopropyl trimethoxy silane, γ-mercaptopropyl triethoxy silane, etc.

These silane coupling agents can be incorporated in the liquid crystal solution at an amount of 0.01∼100 parts by mass based on 100 parts by mass of a thermotropic liquid crystal.

A solidified liquid crystal layer can be formed using a liquid crystal solution containing the aforementioned thermotropic liquid crystal compound, a solvent and, if required, other additives. The coating of the liquid crystal solution can be achieved by, for example, a printing method such as spin-coating, slit-coating, letterpress printing, screen printing, lithography, reverse printing, gravure printing, etc.; a method wherein any of these printing methods is used in combination with an offset system; inkjet method; and bar-coating, etc.

Before coating of the liquid crystal solution, the surface of the transparent substrate may be subjected to an alignment treatment such as rubbing. Alternatively, before coating of the liquid crystal solution, an alignment film for regulating the orientation of the liquid crystal compound may be formed on the surface of transparent substrate. This alignment film can be created by a process wherein a transparent resin layer such as a polyimide layer is formed on the surface of the transparent substrate and then this transparent resin layer is subjected to an alignment treatment such as rubbing. This alignment film may be formed by of optical alignment techniques.

The liquid crystal material layer is formed as a continuous film having a uniform thickness. According to the aforementioned method, the liquid crystal material layer can be formed as a continuous film having a uniform thickness, provided that the surface to be coated is sufficiently flat. In the liquid crystal material layer thus formed, the mesogens of the thermotropic liquid crystal compound are aligned to have a prescribed orientation.

By the expression of "prescribed orientation", it is intended to mean that it may be any kind of orientation as long as the orientation does not generate an in-plane birefringence. For example, the thermotropic liquid crystal compound is constituted by rod-like liquid crystals and the major axis of mesogens is directed in the direction normal to the liquid crystal material layer, thus creating homeotropic orientation (case 1). When a chiral agent exists in the liquid crystal material layer together with the rod-like thermotropic liquid crystal compound, mesogens are helically orientated, thus creating a cholesteric orientation (case 2). Alternatively, the thermotropic liquid crystal compound is constituted by disc-like liquid crystals and the normal direction of the surface of the mesogens is arrayed parallel with the normal direction of the liquid crystal material layer, thus creating a homeotropic orientation (case 3).

The liquid crystal material layer wherein mesogens of the liquid crystal compound constitute a prescribed structure of orientation is then subjected to a prescribed patterning exposure. At this time, the polymerization and/or crosslinking of the thermotropic liquid crystal compound is caused to generate. In the polymerized product or crosslinked product of the thermotropic liquid crystal compound, mesogen groups thereof is immobilized. Namely, in this immobilized state of orientation, the latent pattern image can form. On the other hand, in the region where the light is not irradiated among the entire regions of the liquid crystal layer, the entire liquid crystal compound is kept in an unpolymerized or uncrosslinked state.

More specifically, in the case wherein the rod-like liquid crystal is aligned to take a homeotropic orientation (case 1), when the refractive index of the liquid crystal in the direction of the major axis is represented by "ne" and the direction of the minor axis is represented by "no", the in-plane average refractive index "na" of the region irradiated with light in the step of patterning exposure and exhibiting anisotropy is approximately equal to "no" and the in-plane average refractive index "ni" of the region which is not irradiated with light and exhibiting isotropy is approximately equal to {(ne + 2 x no)/3}. Therefore, since the rod-like liquid crystal is usually defined as ne>no, the in-plane average refractive index "ni" would become ni>na.

In the case wherein the rod-like liquid crystal is aligned to take a cholesteric orientation (case 2), the "na" is approximately equal to {(ne + no)/2} and "ni" would become approximately equal to {(ne + 2 x no)/3}. As described above, since the rod-like liquid crystal is usually defined as ne>no, the index "na" would become na>ni.

In the case wherein the disc-like liquid crystal is aligned to take a homeotropic orientation (case 3), when the refractive index of the liquid crystal in the direction normal to the surface of disc is represented by "ne" and the in-plane direction of disc is represented by "no", the in-plane average refractive index "na" of the region irradiated with light in the step of patterning exposure and exhibiting anisotropy is approximately equal to "no" and the in-plane average refractive index "ni" of the region which is not irradiated with light and exhibiting isotropy is approximately equal to {(ne + 2 x no)/3}. Since the disc-like liquid crystal is usually defined as no>ne, the index "na" would become na>ni.

With respect to the light to be employed in the patterning exposure, it may be electromagnetic waves such as ultraviolet rays, visible light and infrared rays. In place of electromagnetic waves, it is also possible to employ radial rays such as an electron beam, X-rays and gamma rays. In the patterning exposure, only one of these rays may be used or two or more kinds of rays may be used.

As long as it is possible to selectively polymerize or crosslink a prescribed region as described above, the step of patterning exposure may be carried out by any optional method. For example, the step of patterning exposure may be carried out using a photomask having a prescribed pattern. Alternatively, instead of using a photomask, radial rays such as an electron beam or light flux may be scanned over a liquid crystal material layer.

After finishing the step of patterning exposure, the resultant liquid crystal material layer is subjected to a development process. Namely, the liquid crystal material layer is heated to a temperature which is equal to or higher than the phase transition temperature that enables the thermotropic liquid crystal compound to change from the liquid crystal phase to an isotropic phase.

The mesogen moieties of the unreacted portion of the thermotropic liquid crystal compound are not immobilized. Therefore, when the liquid crystal material layer is heated to not lower than the phase transition temperature, the orientation of the mesogens of the unreacted compound is deteriorated. For example, mesogens of the unreacted compound are caused to change from the liquid crystal phase to an isotropic phase. On the other hand, in the polymerized product or crosslinked product of the thermotropic liquid crystal compound, mesogens thereof are immobilized. Therefore, in the region which has been irradiated with light, the orientation of the liquid crystal compound is not caused to change, so that the orientated region is developed in conformity with the exposed pattern.

After the predetermined state in which orientation differs region by region is accomplished, the unreacted compound is enabled to polymerize and/or crosslink while maintaining the state of orientation of the unreacted mesogens. For example, while keeping the liquid crystal material layer at a temperature higher than the phase transition temperature that enables the thermotropic liquid crystal compound to change from the isotropic phase to the liquid crystal phase, the entire liquid crystal material layer is irradiated with light.

The liquid crystal material layer is irradiated with light at such a sufficient quantity of light exposure that enables the polymerization and/or crosslinking reaction to take place in almost all of the unreacted compound. As a result, the polymerization or crosslinking of the unreacted compound takes place, thereby enabling mesogens that has been changed in the state of orientation to immobilize, resulting in the fixing of the pattern. As a result, a solidified liquid crystal layer having a prescribed pattern consisting of an isotropic phase region and an anisotropic phase region, i.e. diffraction grating exhibiting a phase difference, can be obtained.

Incidentally, in some kinds of liquid crystal compound, a first phase transition temperature that brings about the phase change from the isotropic phase to the liquid crystal phase is lower than a second phase transition temperature that brings about the phase change from the liquid crystal phase to the isotropic phase. Therefore, depending on the specific case, the temperature of the liquid crystal material layer at the time of fixing by light may be set lower than the heating temperature at the step of development. However, in viewpoint of convenience, the temperature of the liquid crystal material layer at the time of fixing by light is generally set to not lower than the first phase transition temperature.

The polymerization and/or crosslinking of the unreacted compound may be carried out by other methods.

For example, if any unreacted compound, i.e., the thermotropic liquid crystal compound, is a material which can be polymerized and/or crosslinked through the heating thereof at a polymerization and/or crosslinking temperature which is higher than the first phase transition temperature, the fixing thereof can be performed by heating in place of fixing by light irradiation. More specifically, in place of the fixing process by light, the liquid crystal material layer may be heated to a temperature of not lower than the polymerization and/or crosslinking temperature thereof, thereby achieving the polymerization and/or crosslinking of the unreacted compound. As a result, a solidified liquid crystal layer can be obtained. Incidentally, the heating temperature in the step of development may be not lower than the first phase transition temperature and lower than the polymerization and/or crosslinking temperature thereof.

In this case, in these two successive heating steps, while the region which has not been irradiated with light is transferred into an isotropic phase and hence brought into a substantially non-oriented state, the region which has been irradiated with light is maintained without its prescribed orientation being disturbed even by the heating. Thereafter, the polymerization and/or crosslinking is allowed to proceed while substantially maintaining the state of each of these regions, thereby fixing the pattern and obtaining a phase type diffraction grating.

Alternatively, after finishing the development process, the fixing step by heating and the fixing step by light may be successively executed. Alternatively, after finishing the development process, the fixing step by light and the fixing step by heating may be successively executed. Further, after finishing the development process, the fixing step by heating, the fixing step by light and the fixing step by heating may be successively executed. It is possible, through a combination of the fixing step by light and the fixing step by heating, to reliably carry out the polymerization and/or crosslinking of the unreacted compound. Therefore, it is possible to obtain a more reliable phase-type diffraction grating.

In the phase-type diffraction device according to this embodiment, an antireflection film may be attached to the surface (rear surface) where the solidified liquid crystal layer of transparent substrate 2 is not formed. This antireflections film can be formed on the rear surface of the transparent substrate by the techniques described, for example, in JP Patent No. 3490214, JP Patent No. 3965732 and JP Patent No. 4051740. Although this antireflection film may be formed subsequent to the formation of the solidified liquid crystal layer, it is preferable to execute the formation of this antireflection film before forming the solidified liquid crystal layer if there is a possibility of damaging the solidified liquid crystal layer by the step of forming this antireflection film.

Further, in the phase-type diffraction device according to the present invention, an antistatic film may be attached, after the formation of the solidified liquid crystal layer on the surface of transparent substrate, to a surface opposite to the surface where the transparent substrate of the solidified liquid crystal layer is disposed. This antistatic film may be obtained by depositing a transparent conductive film such as indium tin oxide on the surface of the solidified liquid crystal layer by the resistance heat deposition method, electron beam deposition method, sputtering method, ion plating method, etc.

As described above, it is possible, according to the present invention, to relatively easily and stably obtain a phase-type diffraction device of high quality.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concept as defined by the appended claims and their equivalents.

### Explanation of symbols

10 --- Image pick-up device, 11 --- Image pick-up lens, 1 --- Diffraction device, 2 --- Transparent substrate, 3 --- Solidified liquid crystal layer, 3a --- Optically anisotropic region, 3i --- Optically isotropic region, 12 --- Incident light, 13 --- Diffracted light, 14 --- Separated light spots.

## Claims

1. A phase-type diffraction device **characterized by** comprising:
a transparent substrate having a front surface and a rear surface; and
a solidified liquid crystal layer formed on the front surface of the transparent substrate and constituted by a continuous film comprising at least a liquid crystal compound;
wherein the solidified liquid crystal layer is constituted by first and second regions arranged periodically;
the first region is optically anisotropic and the second region is optically isotropic; and
the first region differs in in-plane average refractive index from the second region.

2. The phase-type diffraction device according to claim 1, **characterized in that** the solidified liquid crystal layer has entirely no in-plane birefringence.

3. The phase-type diffraction device according to claim 1 or 2, **characterized in that** the liquid crystal compound is formed of rod-like liquid crystals, and the first region in the solidified liquid crystal layer has mesogens of the liquid crystal compound immobilized in a state of homeotropic orientation; and the in-plane average refractive index of the first region is smaller than that of the second region.

4. The phase-type diffraction device according to claim 1 or 2, **characterized in that** the liquid crystal compound is formed of rod-like liquid crystals, and the first region in the solidified liquid crystal layer has mesogens of the liquid crystal compound immobilized in a state of cholesteric orientation; and the in-plane average refractive index of the first region is larger than that of the second region.

5. The phase-type diffraction device according to claim 1 or 2, **characterized in that** the liquid crystal compound is formed of disc-like liquid crystals, and the first region in the solidified liquid crystal layer has mesogens of the liquid crystal compound immobilized in a state of homeotropic orientation; and the in-plane average refractive index of the first region is larger than that of the second region.

6. The phase-type diffraction device according to any one of claims 1 to 5, **characterized in that** a period defined by a pair of the first region and the second region is 20 µm or more.

7. The phase-type diffraction device according to any one of claims 1 to 6, **characterized in that** the periodically arranged first and second regions constitute a checkerboard pattern.

8. The phase-type diffraction device according to any one of claims 1 to 7, **characterized in that** a thickness of the solidified liquid crystal layer is entirely uniform.

9. The phase-type diffraction device according to any one of claims 1 to 8, **characterized in that** the transparent substrate is provided, on its rear surface, with an antireflection film.

10. The phase-type diffraction device according to any one of claims 1 to 9, **characterized in that** the solidified liquid crystal layer is provided, on a surface opposite to the surface where the transparent substrate is disposed, with an antistatic film.

11. The phase-type diffraction device according to claim 10, **characterized in that** the antistatic film is formed of indium tin oxide.

12. An image pick-up apparatus comprising an image pick-up device provided with a large number of light-receptive pixels which are periodically arranged and with a phase-type diffraction device according to any one of claims 1 to 11 as a low pass filter.

13. A method of manufacturing a phase-type diffraction device, **characterized by** comprising forming a solidified liquid crystal layer, directly or through another layer, on a front surface of a transparent substrate, the formation of the solidified liquid crystal layer comprising:
a film-forming step of forming, on the front surface of the transparent substrate, a liquid crystal material layer comprising a photo-polymerizable or photo-crosslinkable thermotropic liquid crystal compound, mesogens of the thermotropic liquid crystal compound configuring a prescribed oriented structure;
an exposure step of exposing partial regions of the liquid crystal material layer to light, thereby forming, in the liquid crystal material layer, a first region comprising a reaction product formed of the polymerized or crosslinked thermotropic liquid crystal compound and a second region which is free from the reaction product and comprises unreacted thermotropic liquid crystal compound;
thereafter, a developing step of heating the liquid crystal material layer to a temperature equal to or higher than a phase transition temperature at which the thermotropic liquid crystal compound changes from a liquid crystal phase to an isotropic phase, thereby disturbing the orientation of the mesogens of the unreacted thermotropic liquid crystal compound in the second region to turn the second region into the isotropic phase; and
a fixing step of polymerizing and/or crosslinking the unreacted compound while maintaining a state of the isotropic phase of the second region.

14. The method according to claim 13, **characterized in that** the thermotropic liquid crystal compound comprises rod-like liquid crystals, and the prescribed oriented structure of the mesogens in the liquid crystal material layer is in homeotropic orientation.

15. The method according to claim 13, **characterized in that** the thermotropic liquid crystal compound is formed of rod-like liquid crystals, the liquid crystal material layer further comprises a chiral agent, and the prescribed oriented structure of the mesogens is in cholesteric orientation.

16. The method according to claim 13, **characterized in that** the thermotropic liquid crystal compound comprises disc-like liquid crystals, and the prescribed oriented structure of the mesogens in the liquid crystal material layer is in homeotropic orientation.

17. The method according to any one of claims 13 to 16, **characterized in that** the polymerizing and/or crosslinking of the thermotropic liquid crystal compound in the fixing step is induced by irradiation of light.

18. The method according to any one of claims 13 to 16, **characterized in that** the thermotropic liquid crystal compound is a material that polymerizes and/or crosslinks when heated at a polymerization and/or crosslinking temperature higher than the phase transition temperature;
in the developing step, the orientation of the mesogens is disturbed by heating the liquid crystal material layer to a temperature which is lower than the polymerization and/or crosslinking temperature and not lower than the phase transition temperature; and
in the fixing step, unpolymerized and uncrosslinked thermotropic liquid crystal compounds are polymerized and/or crosslinked by heating the liquid crystal material layer to a temperature not lower than the polymerization and/or crosslinking temperature.

19. The method according to claim 18, **characterized in that** the heating temperature in the fixing step is 200°C or more.

20. The method according to any one of claims 13 to 19, **characterized in that** the liquid crystal material layer is formed as a continuous film having a uniform thickness.

21. The method according to any one of claims 13 to 20, **characterized by** further comprising forming an alignment film on the front surface of transparent substrate before forming the solidified liquid crystal layer.

22. The method according to any one of claims 13 to 21, **characterized by** further comprising forming an antireflection film on a rear surface of the transparent substrate-before the film-forming step.

23. The method according to any one of claims 13 to 22, **characterized by** further comprising the step of forming an antistatic film on a surface of the solidified liquid crystal layer of the fixing step.

24. The method according to claim 23, **characterized in that** the formation of the antistatic film is performed by forming a thin film of indium tin oxide.
